# EUROPÄISCHE PATENTSCHRIFT

(11) **EP 1 826 578 B1**
(45) Veröffentlichungstag und Bekanntmachung des Hinweises auf die Patenterteilung: **27.06.2012**
(21) Anmeldenummer: 07002174.6
(22) Anmeldetag: 01.02.2007
(51) Int. Cl.: G01R 31/28

(54) **Vorrichtung zur Überprüfung einer elektrotechnischen Platine mit einer Leiterbahn**
Device for checking an electrical circuit board with a track
Dispositif pour la vérification d'une platine avec une piste conductrice

(30) Priorität: 23.02.2006 DE 102006008445
(43) Veröffentlichungstag der Anmeldung: 29.08.2007
(73) Patentinhaber: OBO Bettermann GmbH & Co. KG, 58710 Menden (DE)
(72) Erfinder: Schurwanz, Jürgen, Dipl.-Ing., 58708 Menden (DE)
(74) Vertreter: Köchling, Conrad-Joachim

(56) Entgegenhaltungen:
- US-A- 4 362 987
- US-A- 4 769 596
- US-A- 5 109 200
- US-A1- 2005 036 247

## Beschreibung

Die Erfindung betrifft eine Vorrichtung zur Überprüfung einer elektrotechnischen Platine mit einer Leiterbahn, wobei die Leiterbahn einen durchgehenden, nicht an eine Stromquelle angeschlossenen Strompfad bildet, in dem Leiterbahnenabschnitte überbrückt und somit verbunden sind oder mit seriellen elektrotechnischen Bauteilen bestückt und somit verbunden sind.

Im Stand der Technik ist es bekannt, elektrotechnische Platinen, die Leiterbahnen aufweisen, mit anderen elektrotechnischen Komponenten zu kombinieren, beispielsweise mit Blitzstromableitern und Steuerkondensatoren. Eine derartige Ausbildung ist beispielsweise aus der DE 297 24 817 U1 bekannt. Hierbei ist die aus seriell geschalteten Teilfunkenstrecken bestehende Funkenstrecke einerseits an einem Neutralleiter eines Stromversorgungsnetzes angeschlossen, während sie andererseits an Bezugserde, beispielsweise einen Schutzleiter, angeschlossen ist. Bei solchen Blitzstromableitern mit Mehrfachfunkenstreckentechnik werden zur Ansteuerung der einzelnen Funkenstrecken Hochvoltkondensatoren verwendet. Diese Hochvoltkondensatoren befinden sich zusammen mit Federkontakten, die den Kontakt zu den Graphitscheiben der Teilfunkenstrecken herstellen, auf einer Platine. Alle Hochvoltkondensatoren sind auf der einen Seite durch die Leiterbahnen der Platine miteinander seriell verbunden, so dass sie im gleichen Bezugspotential, nämlich Erdpotential, liegen. Bei solchen Einrichtungen, aber auch bei anderen elektrotechnischen Einrichtungen, bei denen eine Platine mit Leiterbahn vorgesehen ist, ist eine Überprüfung und Überwachung der Leiterbahn der Platine notwendig. Beispielsweise kann bei dem beschriebenen Beispiel durch den Blitzstromableitvorgang und den automatisch einsetzenden Folgestromlöschvorgang in der Funkenstrecke Wärme entstehen. Durch die danach folgende Abkühlung wird die Platine mechanisch belastet. Wird der Ableiter häufig sehr hoch belastet, ist es zumindest theoretisch denkbar, dass durch die unterschiedlichen Temperaturausdehnungskoeffizienten der verwendeten Werkstoffe Unterbrechungen durch Risse in der Leiterbahn der Platine entstehen. Eine solche Unterbrechung der Leiterbahn ist auch durch andere Effekte möglich.

Aus der US 4,769,596 A ist eine Vorrichtung der Art bekannt, wie sie im Oberbegriff des Anspruches 1 angegeben ist.

Aufgabe der Erfindung ist es daher, eine Vorrichtung gattungsgemäßer Art zu schaffen, die eine mögliche Unterbrechung der Leiterbahn der Platine überprüfbar macht, und zwar mit geringem Aufwand sowie mit geringem Stromverbrauch.

Zur Lösung dieser Aufgabe schlägt die Erfindung vor, dass eine Prüfschaltung vorgesehen ist, die aus einem ersten Schaltkreis mit einer Induktionsspule (Sekundärspule) und einer ersten Leuchtdiode besteht, wobei der Schaltkreis parallel zur Leiterbahn der Platine geschaltet ist und an die beiden Enden der Leiterbahnen der Platine angeschlossen ist, sowie aus einem zweiten Schaltkreis mit der Induktionsspule (Sekundärspule), einer zweiten Leuchtdiode und einem Schalttransistor, dessen Basis an den ersten Schaltkreis zwischen erster Leuchtdiode und deren Anschluss an die Leiterbahn der Platine angeschlossen ist, wobei die zweite Leuchtdiode an die Kollektor-Emitter-Strecke des Transistors parallel zur Induktionsspule geschaltet ist, und dass ein Primärsender (Primärspule) als Handgerät vorgesehen ist, der ein elektromagnetisches Magnetfeld erzeugt, mittels dessen die Induktionsspule anzuregen ist.

Diese Ausbildung ermöglicht eine Überprüfung der Funktionsfähigkeit der Leiterbahnen der Platine, wobei die Energiezufuhr für die Prüfschaltung nicht aus dem Wechselstromnetz generiert wird, sondern mittels des Primärsenders erfolgt die Energiezuführung nach dem Transformatorprinzip auf die Induktionsspule. Es ist damit die Überprüfung der Platine und der entsprechenden Schaltungsanordnung auch dann möglich, wenn diese zwischen Neutralleiter und Schutzleiter angeschlossen ist, so dass keine eigene Stromquelle verfügbar ist. Durch die erfindungsgemäße Ausbildung erfolgt eine Überprüfung nur dann, wenn eine Person mit dem Primärsender die Induktionsspule erregt.

Es wäre zwar auch eine Lösung denkbar, bei der eine Batterie in den Stromkreis anstelle der Induktionsspule eingesetzt ist, jedoch würde dies einen ständigen Stromverbrauch verursachen und zudem einen turnusmäßigen Ersatz der Batterie erforderlich machen. Diese Wartungsarbeiten sind aber unerwünscht. Durch die Induktivität wird quasi die Sekundärspule eines Transformators gebildet, dessen Primärspule durch den Handsender gebildet ist. Der Handsender kann eine Wechselstromspannungsversorgung aufweisen, oder eine Gleichstromversorgung mit Wechselschaltung. Bei mittels des Handsenders erregter Induktionsspule wird bei funktionsfähiger Leiterbahn der Platine ein geschlossener Stromkreis zwischen den Enden der Leiterbahn der Platine zur Verfügung gestellt, in dem die erste Leuchtdiode eingeschaltet ist, so dass bei erregter Induktionsspule die erste Leuchtdiode leuchtet. Sofern die Leiterbahn einen Defekt aufweist, leuchtet die erste Leuchtdiode nicht auf, sondern die Basis des Schalttransistors wird angesteuert, so dass die Kollektor-Emitter-Strecke des Schalttransistors durchgeschaltet ist. Aus diesem Grunde leuchtet dann die zweite Leuchtdiode, die parallel zur Induktionsspule geschaltet ist, auf und signalisiert den Fehlerzustand der Leiterbahn der Platine.

Zum Schutz des Transistors ist vorgesehen, dass zwischen die erste Leuchtdiode und die Leiterbahn der Platine eine Sperrdiode geschaltet ist, die bis 1000 Volt sperrt.
Aus dem gleichen Grunde ist vorgesehen, dass zwischen die zweite Leuchtdiode und die Leiterbahn der Platine eine Sperrdiode geschaltet ist, die bis 1000 Volt sperrt.

Um dem Benutzer den korrekten Zustand der Leiterbahn der Platine oder den Fehlerzustand deutlich signalisieren zu können, ist vorgesehen, dass die erste Leuchtdiode grünes Licht und die zweite Leuchtdiode rotes Licht emittiert.

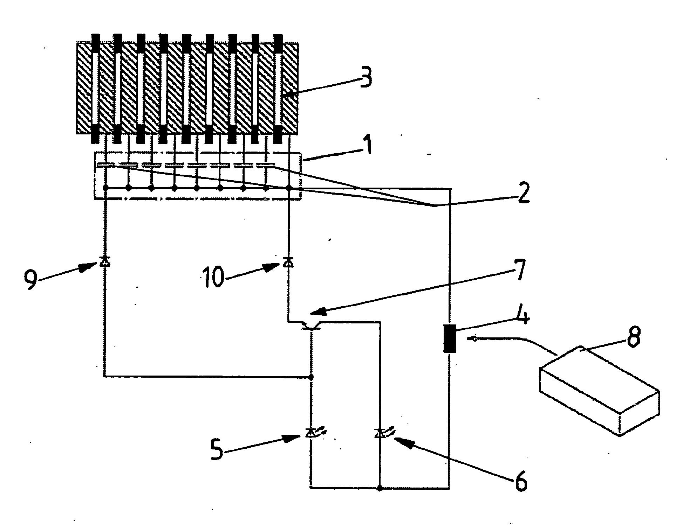

Ein Ausführungsbeispiel der Erfindung ist in der Zeichnung dargestellt und im Folgenden näher beschrieben.

In der Zeichnung ist eine entsprechende Vorrichtung zur Überprüfung einer Platine 1 mit einer Leiterbahn gezeigt. Die Leiterbahn der Platine 1 bildet einen durchgehenden, nicht an eine Stromquelle angeschlossenen Strompfad. Die einzelnen Leiterbahnabschnitte sind überbrückt und somit miteinander verbunden oder mit seriellen elektrotechnischen Bauteilen 2, 3 bestückt. Dabei sind an die Leiterbahn Kondensatoren 2 angeschlossen, die Bestandteil einer blitzstromtragfähigen Funkenstrecke sind, wie dies in der DE 297 24 817 U1 gezeigt ist. Im Ausführungsbeispiel ist eine blitzstromtragfähige Funkenstrecke gezeigt, die aus einer Vielzahl von seriell geschalteten Teilfunkenstrecken 3 besteht. Dabei sind die Teilfunkenstrecken 3 mit Ausnahme der im Blitzstromereignisfall ansprechenden ersten Teilfunkenstrecke durch Impedanzen in Form von Kondensatoren 2 geschaltet, so dass sie sukzessive durchschalten. Die zweite und jede weitere Teilfunkenstrecke ist über die Impedanzen (Kondensatoren 2) direkt an ein gemeinsames Bezugspotential, beispielsweise Erdpotential angeschaltet. Bei einzelnen Leiterbahnabschnitten der Platine 1 sind durch die angeschlossenen Teilfunkenstrecken und Impedanzen, die seriell zueinander geschaltet sind, überbrückt. Den anderen Anschluss an die Funkenstrecke bildet ein Neutralleiter. Die Funkenstrecke ist damit nicht mit einer eigenen Energiezuführung versehen.

Die Prüfschaltung selbst besteht aus einem ersten Schaltkreis mit einer Induktionsspule 4, die die Funktion einer Sekundärspule eines Transformators erfüllt, und einer ersten Leuchtdiode 5, wobei dieser Schaltkreis parallel zur Leiterbahn der Platine 1 geschaltet ist und an die beiden Enden der Leiterbahn der Platine 1 angeschlossen ist. Ferner ist ein zweiter Schaltkreis vorgesehen, der aus der Induktionsspule 4, einer zweiten Leuchtdiode 6 und einem Schalttransistor 7 besteht. Die Basis des Schalttransistors 7 ist an den ersten Schaltkreis zwischen erster Leuchtdiode 5 und deren Anschluss an die Leiterbahn der Platine 1 angeschlossen und somit steuerbar. Dabei ist die zweite Leuchtdiode 6 an die Kollektor-Emitter-Strecke des Transistors 7 parallel zur Induktionsspule 4 geschaltet, also zum gleichen Anschluss an die Platine 1 geführt, an den auch die Induktionsspule 4 angeschlossen ist. Zur Erregung der Induktionsspule 4 ist ein Primärsender 8 als Handgerät vorgesehen, mittels dessen ein elektrisches Wechselfeld erzeugbar ist, welches wiederum dazu geeignet und bestimmt ist, die Induktionsspule 4 im Falle der Annäherung des Handsenders 8 an diese anzuregen. Sofern also der Handsender 8 der Induktionsspule 4 angenähert wird, wird diese angeregt und es wird ein entsprechender Gleichstrom zur Versorgung der Prüfschaltung erzeugt. Im Falle einer korrekten Leiterbahn der Platine 1 leuchtet in diesem Falle die erste Leuchtdiode 5 auf und signalisiert den korrekten Zustand der Leiterbahn der Platine. Weist die Leiterbahn der Platine 1 Unterbrechungen auf, so ist der Stromkreis über die erste Leuchtdiode 5 nicht geschlossen. In diesem Falle steuert der geringe Strom, der über die Leuchtdiode 5 noch fließt, die Basis des Schalttransistors 7, so dass dieser durchschaltet und die parallel zur Induktionsspule 4 geschaltete zweite Leuchtdiode 6 aufleuchtet. Diese signalisiert den Fehlerzustand der Leiterbahn der Platine 1. Die zweite Leuchtdiode 6 ist dabei parallel zur Induktionsspule 4 geschaltet und zu deren Anschluss an der Leiterplatte 1 zurückgeführt. Zum Schutz des Schalttransistors 7 ist zwischen die erste Leuchtdiode 5 und deren leiterplattenseitigen Anschluss eine Sperrdiode 9 eingeschaltet und an die Kollektor-Emitter-Strecke des Transistors 7 ist ebenfalls eine Sperrdiode 10 angeschlossen, die wiederum mit dem Anschlusspunkt der Induktionsspule 4 an der Leiterbahn der Platine 1 in Verbindung steht.

Um den ordnungsgemäßen Zustand beziehungsweise den Fehlerzustand der Leiterbahn der Platine 1 deutlich zu signalisieren, emittiert die erste Leuchtdiode 5 grünes Licht, während die zweite Leuchtdiode 6 rotes Licht emittiert.

Die Erfindung ist nicht auf das Ausführungsbeispiel beschränkt, sondern im Rahmen der Ansprüche vielfach variabel.

## Patentansprüche

1. Vorrichtung zur Überprüfung einer elektrotechnischen Platine (1) mit einer Leiterbahn, wobei die Leiterbahn einen durchgehenden, nicht an eine Stromquelle angeschlossenen Strompfad bildet, in dem Leiterbahnenabschnitte überbrückt und somit verbunden sind oder mit seriellen elektrotechnischen Bauteilen (2, 3) bestückt und somit verbunden sind, **dadurch gekennzeichnet, dass** eine Prüfschaltung vorgesehen ist, die aus einem ersten Schaltkreis mit einer Induktionsspule (4) - d.h. Sekundärspule -und einer ersten Leuchtdiode (5) besteht, wobei der Schaltkreis parallel zur Leiterbahn der Platine (1) geschaltet ist und an die beiden Enden der Leiterbahnen der Platine (1) angeschlossen ist, sowie aus einem zweiten Schaltkreis mit der Induktionsspule (4), einer zweiten Leuchtdiode (6) und einem Schalttransistor (7), dessen Basis an den ersten Schaltkreis zwischen erster Leuchtdiode (5) und deren Anschluss an die Leiterbahn der Platine (1) angeschlossen ist, wobei die zweite Leuchtdiode (6) an die Kollektor-Emitter-Strecke des Transistors (7) parallel zur Induktionsspule (4) geschaltet ist, und dass ein Primärsender (8) - d.h. Primärspule -als Handgerät vorgesehen ist, der ein elektromagnetisches Magnetfeld erzeugt, mittels dessen die Induktionsspule (4) anzuregen ist.

2. Vorrichtung nach Anspruch 1, **dadurch gekennzeichnet, dass** zwischen die erste Leuchtdiode (5) und die Leiterbahn der Platine (1) eine Sperrdiode (9) geschaltet ist, die bis 1000 Volt sperrt.

3. Vorrichtung nach Anspruch 1 oder 2, **dadurch gekennzeichnet, dass** zwischen die zweite Leuchtdiode (6) und die Leiterbahn der Platine (1) eine Sperrdiode (10) geschaltet ist, die bis 1000 Volt sperrt.

4. Vorrichtung nach einem der Ansprüche 1 bis 3, **dadurch gekennzeichnet, dass** die erste Leuchtdiode (5) grünes Licht und die zweite Leuchtdiode (6) rotes Licht emittiert.

## Claims

1. An apparatus for checking an electrical printed circuit board (1) having a conductor track, wherein the conductor track forms a continuous current path not connected to a current source by conductor track portions being bridged and thus connected or being equipped with serial electrical components (2, 3) and thus connected, **characterised in that** a test circuit is provided, consisting of a first circuit comprising an induction coil (4) - i.e. a secondary coil - and a first light-emitting diode (5), wherein the circuit is connected in parallel to the conductor track of the printed circuit board (1) and to the two ends of the conductor tracks of the printed circuit board (1), and of a second circuit comprising the induction coil (4), a second light-emitting diode (6) and a switching transistor (7) connected by its base to the first circuit between the first light-emitting diode (5) and the connection thereof to the conductor track of the printed circuit board (1), wherein the second light-emitting diode (6) is connected to the collector/emitter section of the transistor (7) in parallel to the induction coil (4), and that a primary transmitter (8) - i.e. a primary coil - is provided as a manual device generating an electromagnetic field by means of which the induction coil (4) can be excited.

2. The apparatus according to claim 1, **characterised in that** a blocking diode (9), which blocks up to 1,000 Volt, is connected between the first light-emitting diode (5) and the conductor track of the printed circuit board (1).

3. The apparatus according to claim 1 or 2, **characterised in that** a blocking diode (10), which blocks up to 1,000 Volt, is connected between the second light-emitting diode (6) and the conductor track of the printed circuit board (1).

4. The apparatus according to one of claims 1 to 3, **characterised in that** the first light-emitting diode (5) emits green light, and that the second light-emitting diode (6) emits red light.

## Revendications

1. Dispositif de contrôle d'une platine électrotechnique (1) avec une piste conductrice, la piste conductrice formant un chemin de courant ininterrompu non connecté à une source de courant, des sections de piste conductrice étant court-circuitées et donc reliées ou équipées de composants électrotechniques (2, 3) série et donc reliées, **caractérisé en ce qu'**un circuit de contrôle est prévu composé d'un premier circuit comprenant une bobine d'induction (4) - c'est-à-dire une bobine secondaire - et une première diode luminescente (5), le circuit étant monté en parallèle sur la piste conductrice de la platine (1) et étant connecté aux deux extrémités des pistes conductrices de la platine (1), et un deuxième circuit comprenant la bobine d'induction (4), une deuxième diode luminescente (6) et un transistor de commutation (7) connecté par sa base au premier circuit entre la première diode luminescente (5) et la connexion de celle-ci à la piste conductrice de la platine (1), la deuxième diode luminescente (6) étant connectée au trajet collecteur-émetteur du transistor (7) en parallèle à la bobine d'induction (4), et qu'un émetteur primaire (8) - c'est-à-dire une bobine primaire - est prévu comme dispositif manuel générant un champ électromagnétique, au moyen duquel la bobine d'induction (4) peut être excitée.

2. Dispositif selon la revendication 1, **caractérisé en ce qu'**entre la première diode luminescente (5) et la piste conductrice de la platine (1) est montée une diode de blocage (9) qui bloque jusqu'à 1000 volts.

3. Dispositif selon la revendication 1 ou 2, **caractérisé en ce qu'**entre la deuxième diode luminescente (6) et la piste conductrice de la platine (1) est montée une diode de blocage (10) qui bloque jusqu'à 1000 volts.

4. Dispositif selon une des revendications 1 à 3, **caractérisé en ce que** la première diode luminescente (5) émet une lumière verte, et que la deuxième diode luminescente (6) émet une lumière rouge.
